Europäisches Patentamt

European Patent Office

Office européen des brevets

(19)

(11) Veröffentlichungsnummer: **0 045 446**

**A1**

## (12) EUROPÄISCHE PATENTANMELDUNG

(21) Anmeldenummer: 81105801.5

(22) Anmeldetag: 22.07.81

(51) Int. Cl.³: **H 01 L 21/302**
**C 23 F 1/04, B 28 D 5/00**

(30) Priorität: 06.08.80 DE 3029792

(43) Veröffentlichungstag der Anmeldung:
10.02.82 Patentblatt 82/6

(84) Benannte Vertragsstaaten:
CH DE FR GB IT LI

(71) Anmelder: SIEMENS AKTIENGESELLSCHAFT Berlin
und München
Postfach 22 02 61
D-8000 München 22(DE)

(72) Erfinder: Kolbesen, Bernd, Dr.
Leopoldstrasse 136
D-8000 München 40(DE)

(54) Verfahren zum Zerteilen eines Halbleiterkristalls in Scheiben.

(57) Die Erfindung betrifft ein Verfahren zum Zerteilen eines, insbesondere stabförmigen Halbleiterkristalls in Scheiben, bei dem der Halbleiterkristall mit einer von Streifen unterbrochenen Maskierschicht aus nichtleitendem Material versehen wird, anschließend als Anode vorgespannt und in einen mit einer als Kathode wirkenden Elektrode versehenen Elektrolyten getaucht wird und bei dem dann die in den nicht maskierten Bereichen des Halbleiterkristalls entstehenden Oxidschichten mechanisch entfernt werden.

FIG 1

EP 0 045 446 A1

SIEMENS AKTIENGESELLSCHAFT · VPA 80 P 1122 E
Berlin und München

Verfahren zum Zerteilen eines Halbleiterkristalls in Scheiben

Die Erfindung betrifft ein Verfahren zum Zerteilen eines, insbesondere stabförmigen Halbleiterkristalls in Scheiben.

Halbleiterbauelemente, wie z.B. Dioden, Transistoren, Thyristoren, integrierte Schaltkreise oder Solarzellen, werden in der Regel aus Halbleiterscheiben hergestellt, die von stabförmigen, meist einkristallinen Halbleiterkristallen abgetrennt werden. Zum Abtrennen der Scheiben werden mechanische Sägeverfahren, die hauptsächlich nach dem Innenlochsägeprinzip arbeiten, verwendet. Eine entsprechende Innenlochsäge ist beispielsweise aus der DE-AS 22 04 491 bekannt. Diese Sägeverfahren haben zum einen den Nachteil, daß der Verlust an Halbleitermaterial, bezogen auf die Scheibendicke, 50 bis 100 % beträgt. Zum anderen muß bei diesen Verfahren Scheibe um Scheibe abgetrennt werden, der Aufwand sowohl in zeitlicher als auch in apparativer Hinsicht ist daher nicht unbedeutend.

Aufgabe der vorliegenden Erfindung ist es, hier Abhilfe zu schaffen und ein Verfahren zum Zerteilen von Halbleiterkristallen in Scheiben vorzusehen, bei dem im Vergleich zu den bekannten Verfahren eine erheblich geringere Abfallmenge anfällt.

Diese Aufgabe wird erfindungsgemäß dadurch gelöst, daß der Halbleiterkristall mit einer von Streifen unterbrochenen Maskierschicht aus nichtleitendem Material

4.3.80
Nte 1 Si

0045446

80 P 1122 E

versehen wird, daß der Halbleiterkristall als Anode vorgespannt und in einen mit einer als Kathode wirkenden Elektrode versehenen Elektrolyten getaucht wird und daß die in den nicht maskierten Bereichen des Halbleiterkristalls entstehenden Oxidschichten mechanisch entfernt werden. Damit wird es ermöglicht, die bei der Zerteilung anfallende Abfallmenge an Halbleitermaterial erheblich zu verringern und den zum Zerteilen notwendigen technischen Aufwand gering zu halten.

Bei Verwendung eines stabförmigen Halbleiterkörpers ist es von Vorteil, die die Maskierschicht unterbrechenden Streifen parallel zueinander und ringförmig in in etwa senkrecht zur Kristallängsachse stehenden Ebenen anzuordnen.

Die Maskierschicht kann beispielsweise mittels eines fotolithografischen Prozesses, mittels Ritzen oder mittels Laserbestrahlung streifenförmig unterbrochen werden, so daß nur an den Stellen, an denen die Maskierschicht am Kristallstabmantel entfernt bzw. beschädigt ist, das Ätzmittel den Halbleiterstab angreifen kann.

Es ist von Vorteil, daß die Maskierschicht durch 50 bis 200 $\mu$m, insbesondere 80 bis 120 $\mu$m breite Streifen unterbrochen wird und daß die Maskierschicht in Abständen von mindestens 200 $\mu$m streifenförmig unterbrochen wird.

Es liegt im Rahmen der Erfindung, daß ein fluoridhaltiger Elektrolyt, z.B. Flußsäure, verwendet wird, daß als Maskierschicht ein Oxid, insbesondere $SiO_2$ oder $Al_2O_3$, oder $Si_3N_4$ verwendet wird, daß die im nicht maskierten Bereich des Halbleiterkristalls entstehenden Oxidschichten durch die mechanische Einwirkung mindestens eines Drahtes oder Blattes entfernt werden, daß die mechanische Einwirkung durch Hin- und Herbewegung des Drahtes oder des Blattes bewirkt wird, daß die mechanische Einwirkung senkrecht zur Oberfläche des Halbleiterkristalles ausgeübt wird, und daß ein Draht oder ein Blatt aus Metall, insbesondere Eisen, Kupfer oder Molybdän, verwendet wird.

Zur Verkürzung der Bearbeitungszeit ist es von Vorteil, mehrere parallel zueinander angeordnete Drähte oder Blätter zu verwenden, den Halbleiterkristall um seine Längsachse, beispielsweise mit einer im Bereich zwischen etwa 1 bis 10 U/min gewählten Geschwindigkeit zu drehen und den Elektrolyten auf eine geeignete Temperatur zu erwärmen.

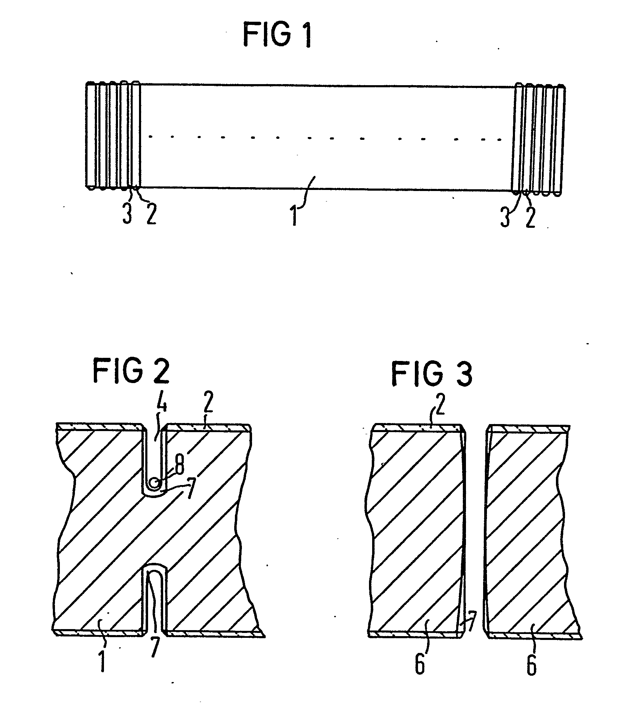

Die Erfindung wird im folgenden anhand der als Ausführungsbeispiel zu wertenden Figuren 1 bis 3 näher erläutert.

Die Figur 1 zeigt einen mit einer Maskierschicht, die von ringförmigen Streifen unterbrochen wird, versehenen Halbleiterkristallstab. Die Figuren 2 und 3 zeigen ausschnittsweise den Kristallstab in unterschiedlichen Verfahrensabschnitten im Schnitt.

Die Figur 1 zeigt einen rundgeschliffenen Silicium-Kristallstab 1, der mit einer, aus Gründen der Einfachheit nur teilweise dargestellten Maskierschicht 2 bedeckt wurde und bei dem die Maskierschicht 2 in äquidistanten Abständen in Form von ringförmigen Streifen 3 entfernt wurde. Die ringförmigen Streifen 3 sind parallel zueinander in senkrecht zur Kristallängsachse stehenden Ebenen angeordnet. Die Streifen 3 können durch ein fototechnisches Verfahren mit anschließender Ätzung, durch Ritzen, durch Laserbestrahlung oder eine andere Technik erzeugt werden.

-4-

Es genügt, die Maskierschicht so zu beschädigen, daß der Elektrolyt später an diesen Stellen das Silicium angreifen kann.

Anschließend wird der mit ringförmigen Streifen 3 versehene Silicium-Kristallstab 1 in ein mit einem Elektrolyten, beispielsweise Flußsäure, gefülltes Bad eingebracht. Der Siliciumkristall wird als Anode vorgespannt, während eine im elektrolytischen Bad angeordnete Metallelektrode als Kathode dient. Der an den Stellen des Siliciumkristalls, die nicht von der Maskierschicht 2 bedeckt sind, nämlich an den ringförmigen Streifen 3, fließende Strom führt zur Bildung einer Oxidschicht 7 auf den stromdurchflossenen Flächen, die den weiteren Stromfluß beeinträchtigt. Durch mechanische Einwirkung eines senkrecht zur Längsachse des Siliciumkristalls 1 angeordneten Metalldrahtes 8, z.B. eine Hin- und Herbewegung des Drahtes 8, wobei in Richtung Stabmitte Druck ausgeübt wird, wird der parallel zur Stabmantelfläche liegende Teil der Oxidschicht 7 ständig entfernt, so daß sich im Halbleiterstab 1 Rillen 4 bilden.

Wird der Halbleiterstab 1 während der Durchführung des Verfahrens um seine Längsachse gedreht, so sind die Rillen 4, wie in der Figur 2 dargestellt, ringförmig. Bei Weiterführung des Verfahrens zerfällt der Halbleiterstab 1, wie in der Figur 3 ausschnittsweise gezeigt, in einzelne Scheiben 6.

Vorteilhaft ist es, der Anzahl der Streifen 3 entsprechend viele parallel zueinander ausgerichtete Drähte 8 oder entsprechende Metallblätter vorzusehen. Dadurch wird es ermöglicht, daß nicht wie bei den bekannten mechanischen Sägeverfahren Scheibe um Scheibe einzeln, sondern alle Scheiben aus einem Stab gleichzeitig abgetrennt werden.

Dabei können je nach Größe des elektrolytischen Bades auch mehrere Halbleiterstäbe auf einmal in Scheiben getrennt werden. Der Verlust an Halbleitermaterial bzw. Silicium beim erfindungsgemäßen Verfahren ist mindestens um 50 % geringer als bei herkömmlichen mechanischen Sägeverfahren.

Die maskierende Schicht 2 sollte vom Elektrolyten nicht oder mindestens um den Faktor $10^4$ bis $10^6$ langsamer angegriffen werden als das zu oxidierende Halbleitermaterial. Als isolierende Maskierschicht können Oxide, z.B. $Al_2O_3$ oder nichtleitende Siliciumverbindungen verwendet werden. Die Maskierschicht kann durch thermische Oxidation, durch Aufdampfen, Kathodenzerstäubung, Galvanik oder ähnliche Verfahren aufgebracht werden.

Nach dem erfindungsgemäßen Verfahren können außer Silicium, dem häufigsten Anwendungsfall, auch andere Halbleiter, wie beispielsweise Germanium oder III-V-Verbindungen in einkristalliner oder polykristalliner Form behandelt werden. Werden bei Halbleiterstäben die die Maskierschicht unterbrechenden Streifen nicht ringförmig am Kristallmantel, sondern parallel zur Stabachse am Kristallmantel angeordnet, so ist es möglich, den Halbleiterstab nicht in ringförmige, sondern in bretterförmige Scheiben bzw. Platten, deren Länge im wesentlichen mit der Länge des Halbleiterstabes identisch ist, zu trennen. Entspechende, insbesondere aus Siliciumstäben oder -blöcken hergestellte Bretter können mit Vorteil zu Solarzellen weiterverarbeitet werden, bzw. als Ausgangsmaterial für großflächige Solarzellen dienen.

Die Breite der streifenförmigen Unterbrechungen 3 der Maskierschicht 2 sollten im Bereich zwischen 50 und 200 μm

gewählt werden, da sonst einerseits die Festigkeit des Drahtes 8 zu gering und andererseits der Verschnittanfall zu groß ist. Vorteilhaft ist eine Breite der Streifen 3 im Bereich von 80 bis 120 $\mu$m. Der Abstand zwischen den einzelnen Streifen 3 sollte für selbsttra-gende Siliciumscheiben mindestens 200 $\mu$m betragen und hängt im übrigen von der Verwendung der abgetrennten Scheiben ab. Die Draht- bzw. Blattbreite wird entsprechend der benutzten Streifenbreite gewählt. Als Material für den Draht 8 bzw. ein Blatt kommen Metalle wie beispielsweise Eisen, Kupfer oder Molybdän in Frage.

Beispiel:

Ein Silicium-Einkristallstab mit 100 mm Durchmesser wird zunächst - u.a. um einen gleichmäßigen Maskierungsüberzug zu erreichen - rundgeschliffen. Anschließend wird eine ca. 1 $\mu$m dicke Maskierschicht 2 aus Aluminiumoxid aufgebracht. Sodann wird die Maskierschicht 2 mittels eines fotolithograhischen Prozesses in ca. 100 $\mu$m breiten ringförmigen Streifen 3, die in Abständen von etwa 400 $\mu$m angeordnet sind, entfernt. Anschließend wird der Siliciumkristall in einem Bad aus 10-prozentiger Flußsäure um seine Längsachse drehbar gehaltert, eine als Kathode dienende Metallelektrode im Elektrolyten angebracht und der Siliciumkristall mit 10 Volt als Anode vorgespannt. Als Trenndraht wurde ein Molybdändraht mit 100 $\mu$m Querschnitt ver-wendet. Das Trennen der Scheiben dauerte bei 25 $^{\circ}$C Elektrolyttemperatur und bei einer Umdrehungsrate des Stabes von 7 U/min ca. 3 Tage. Die seitliche Unteroxidie-rung beträgt dann ca. 100 $\mu$m, d.h. je 50 $\mu$m zur Seite. Bei einer ursprünglichen Streifenbreite von 100 $\mu$m beträgt somit der Siliciumverlust ca. 200 $\mu$m. Dies entspricht bei einer ursprünglichen Scheibendicke von 400 $\mu$m 50 % Verlust an Silicium durch die elektrolytisch-mechanische Trennung. Bei herkömmlichen Sägeverfahren beträgt dagegen der Sägeverlust bis zu 100 %, bezogen auf die Scheibendicke.

Gleiche Ergebnisse werden erreicht, wenn Siliciumdioxid als Maskierschicht verwendet wird und die Maskierschicht durch Ritzen mit einem Diamanten streifenförmig unterbrochen wird.


3 Figuren
20 Patentansprüche

·0045446

80 P 1122 E

Patentansprüche

1. Verfahren zum Zerteilen eines, insbesondere stabför-migen Halbleiterkristalls in Scheiben, d a d u r c h  g e k e n n z e i c h n e t, daß der Halbleiterkristall mit einer von Streifen unterbrochenen Maskierschicht aus nichtleitendem Material versehen wird, daß der Halbleiterkristall als Anode vorgespannt und in einen mit einer als Kathode wirkenden Elektrode versehenen Elektrolyten getaucht wird und daß die in den nicht maskierten Bereichen des Halbleiterkristalls entstehenden Oxidschichten mechanisch entfernt werden.

2. Verfahren nach Anspruch 1, d a d u r c h  g e k e n n-z e i c h n e t, daß bei Verwendung eines stabförmigen Halbleiterkristalls die die Maskierschicht unterbrechenden Streifen parallel zueinander und ringförmig in in etwa senkrecht zur Kristallängsachse stehenden Ebenen angeordnet werden.

3. Verfahren nach Anspruch 1 oder 2, d a d u r c h  g e-k e n n z e i c h n e t, daß die Maskierschicht mittels eines fotolithografischen Prozesses streifenförmig unterbrochen wird.

4. Verfahren nach wenigstens einem der Ansprüche 1 bis 3, d a d u r c h  g e k e n n z e i c h n e t, daß die Maskier-schicht mittels Ritzens streifenförmig unterbrochen wird.

5. Verfahren nach wenigstens einem der Ansprüche 1 bis 4, d a d u r c h  g e k e n n z e i c h n e t, daß die Maskier-schicht mittels Laserbestrahlung streifenförmig unterbrochen wird.

6. Verfahren nach wenigstens einem der Ansprüche 1 bis 5, d a d u r c h  g e k e n n z e ic h n e t, daß die Maskier-

schicht durch 50 bis 200 $\mu$m, insbesondere 80 bis 120 $\mu$m breite Streifen unterbrochen wird.

7. Verfahren nach wenigstens einem der Ansprüche 1 bis 6, d a d u r c h   g e k e n n z e i c h n e t, daß die Maskierschicht in Abständen von mindestens 200 $\mu$m streifenförmig unterbrochen wird.

8. Verfahren nach wenigstens einem der Ansprüche 1 bis 7, d a d u r c h   g e k e n n z e i c h n e t, daß ein fluoridhaltiger Elektrolyt verwendet wird.

9. Verfahren nach wenigstens einem der Ansprüche 1 bis 8, d a d u r c h   g e k e n n z e i c h n e t, daß als Elektrolyt verdünnte Flußsäure verwendet wird.

10. Verfahren nach wenigstens einem der Ansprüche 1 bis 9, d a d u r c h   g e k e n n z e i c h n e t, daß als Maskierschicht ein Oxid, insbesondere $SiO_2$ oder $Al_2O_3$ verwendet wird.

11. Verfahren nach wenigstens einem der Ansprüche 1 bis 10, d a d u r c h   g e k e n n z e i c h n e t, daß als Maskierschicht $Si_3N_4$ verwendet wird.

12. Verfahren nach wenigstens einem der Ansprüche 1 bis 11, d a d u r c h   g e k e n n z e i c h n e t, daß die im nicht maskierten Bereich des Halbleiterkristalls entstehenden Oxidschichten durch die mechanische Einwirkung mindestens eines Drahtes oder Blattes entfernt werden.

13. Verfahren nach wenigstens einem der Ansprüche 1 bis 12, d a d u r c h   g e k e n n z e i c h n e t, daß die mechanische Einwirkung durch Hin- und Herbewegung des Drahtes oder des Blattes bewirkt wird.

0045446

80 P 1122 E

14. Verfahren nach wenigstens einem der Ansprüche 1 bis 13, d a d u r c h   g e k e n n z e i c h n e t, daß die mechanische Einwirkung senkrecht zur Oberfläche des Halbleiterkristalls ausgeübt wird.

15. Verfahren nach wenigstens einem der Ansprüche 1 bis 14, d a d u r c h   g e k e n n z e i c h n e t, daß ein Draht oder ein Blatt aus Metall, insbesondere Eisen, Kupfer oder Molybdän, verwendet wird.

16. Verfahren nach wenigstens einem der Ansprüche 1 bis 15, d a d u r c h   g e k e n n z e i c h n e t, daß mehrere parallel zueinander angeordnete Drähte oder Blätter verwendet werden.

17. Verfahren nach wenigstens einem der Ansprüche 1 bis 16, d a d u r c h   g e k e n n z e i c h n e t, daß der Halbleiterkristall um seine Längsachse gedreht wird.

18. Verfahren nach wenigstens einem der Ansprüche 1 bis 17, d a d u r c h   g e k e n n z e i c h n e t, daß der Halbleiterkristall mit einer Geschwindigkeit im Bereich zwischen etwa 1 bis 10 U/min gedreht wird.

19. Verfahren nach wenigstens einem der Ansprüche 1 bis 18, d a d u r c h   g e k e n n z e i c h n e t, daß der Elektrolyt auf eine geeignete Temperatur erwärmt wird.

20. Halbleiterscheibe, hergestellt nach wenigstens einem der in den Ansprüchen 1 bis 19 beschriebenen Verfahren.

1/1

## FIG 1

3 2      1      3 2

## FIG 2

4   2

8

7

1   7

## FIG 3

2

7

6   6

0045446

Europäisches
Patentamt

**EUROPÄISCHER RECHERCHENBERICHT**

Nummer der Anmeldung

EP 81 10 5801.5

## EINSCHLÄGIGE DOKUMENTE

| Kategorie | Kennzeichnung des Dokuments mit Angabe, soweit erforderlich, der maßgeblichen Teile | betrifft Anspruch |
|---|---|---|
| | DE - A - 1 521 978 (SIEMENS) <br> * Ansprüche 1 bis 3, 6, 7, 9 bis 11; Seite 5, Zeile 19 bis Seite 7, Zeile 14; Fig. * <br><br> -- <br><br> DE - C - 823 470 (SIEMENS & HALSKE) <br> * Ansprüche 1, 2 * <br><br> -- | 1,12-17,19 <br><br><br><br><br> 1,4 |
| A | JOURNAL OF THE ELECTROCHEMICAL SOCIETY, Band 127, Nr. 2, February 1980 Princeton <br> T. UNAGAMI " Formation Mechanism of Porous Silicon Layer by Anodization in HF Solution" <br> Seiten 476 bis 483 <br> * Seite 476, Absätze 4 bis 6 * <br><br> ---- | 9 |

**KLASSIFIKATION DER ANMELDUNG (Int. Cl.³)**

H 01 L 21/302
C 23 F 1/04
B 28 D 5/00

**RECHERCHIERTE SACHGEBIETE (Int. Cl.³)**

B 28 D 5/00
C 23 F 1/00
C 30 B 23/00
H 01 L 21/30

**KATEGORIE DER GENANNTEN DOKUMENTE**

X: von besonderer Bedeutung
A: technologischer Hintergrund
O: nichtschriftliche Offenbarung
P: Zwischenliteratur
T: der Erfindung zugrunde liegende Theorien oder Grundsätze
E: kollidierende Anmeldung
D: in der Anmeldung angeführtes Dokument
L: aus andern Gründen angeführtes Dokument
&: Mitglied der gleichen Patentfamilie, übereinstimmendes Dokument

X | Der vorliegende Recherchenbericht wurde für alle Patentansprüche erstellt.

| Recherchenort | Abschlußdatum der Recherche | Prüfer |
|---|---|---|
| Berlin | 30-10-1981 | GIBBS |

EPA form 1503.1 06.78